# EUROPEAN PATENT SPECIFICATION

(11) **EP 2 048 895 B1**
(45) Date of publication and mention of the grant of the patent: **06.12.2017**
(21) Application number: 08166090.4
(22) Date of filing: 08.10.2008
(51) Int. Cl.: H04R 25/00, G06F 17/50

(54) **A computerized rule-based binaural modeling system and method for hearing aid design**
Computergestütztes regelbasiertes binaurales Formsystem und Verfahren für Hörgeräte
Système de modélisation binaurale informatisée à base de règles et procédé pour la conception d'une assistance auditive

(30) Priority: 12.10.2007 US 871213
(43) Date of publication of application: 15.04.2009
(73) Proprietor: Sivantos, Inc., Piscataway, NJ 08854 (US)
(72) Inventor: McBagonluri, Fred, East Windsor, NJ 08520 (US); Boltyenkov, Artem, Lawrenceville, NJ 08648-4322 (US); Lamba, Lavlesh, Piscataway, NJ 08854 (US)
(74) Representative: FDST Patentanwälte

(56) References cited:
- WO-A-2006/103236
- US-A1- 2002 196 954
- US-A1- 2004 107 080
- US-A1- 2004 165 741

## Description

### BACKGROUND

The present invention is directed towards the field of hearing aid modeling systems, and particularly towards a computerized rule-based binaural modeling system and appertaining method for hearing aid design. This application is related to U.S. Patent publication no. 20090099677; WO2006/103236; and US Patent publication no. US20090097724.

Hearing aid design has historically been a manually intensive task and has relied on heuristics and ad hoc methods that had evolved over time. Recent advances in three-dimensional modeling technologies have lent themselves to the design of hearing aids, permitting a more robust and rule-based mechanism for hearing aid design that eliminates much of the guesswork that previously was utilized in the manual process.

Abbreviations used herein are as follows:
- CA: Canal hearing aid design
- CIC: Completely-in-canal hearing aid design
- DWOM: Digital work order management
- HS: Half shell hearing aid design
- ITE: In-the-ear (full shell) hearing aid design
- MC: Mini canal hearing aid design

### SUMMARY

The invention includes an embodiment which is a method for designing and building a hearing aid, comprising: entering a work order for a hearing aid which includes a digitized 3D shell model having feature data; performing at least one of smoothing, hole filling, outlier removal, and rendering based on the shell model; analyzing the shell model to recognize features and determine relevant parameters associated with the features; registering and storing, in a data store, the recognized features and associated parameters; implementing a rule-based protocol handling for the shell model that is determined based on a determined shell type; performing global and local offsets on data associated with the shell model; performing binaural processing to augmented detailing and modeling protocols used on the shell model; and creating a hearing aid based on the shell model processed according to the preceding steps.

The invention further includes an embodiment including a computer system for automatically designing and building a hearing aid, comprising: a processor for executing software algorithms; an input and an output associated with the processor; a user interface device for accessing the processor; a memory for storing the software algorithms; wherein the software algorithms comprise: an algorithm for entering a work order for a hearing aid which includes a digitized 3D shell model having feature data; an algorithm for performing at least one of smoothing, hole filling, outlier removal, and rendering based on the shell model; an algorithm for analyzing the shell model to recognize features and determine relevant parameters associated with the features; an algorithm for registering and storing, in a data store, the recognized features and associated parameters; an algorithm for implementing a rule-based protocol handling for the shell model that is determined based on a determined shell type; an algorithm for performing global and local offsets on data associated with the shell model; and an algorithm for performing binaural processing to augmented detailing and modeling protocols used on the shell model. A further embodiment includes a computer readable media for storing executable code that implements the algorithms.

The present system differs from other modeling systems in the sense that it identifies characteristic features of the ear canal and defines rule based protocols for designing a custom hearing aid for the patient. This system combines feature recognition, buildability index computation (BIA) implementation and binaural processing to augmented detailing and modeling protocols.

The embodiments of the invention develop advanced rule-based protocols to enable automatic modeling, detailing and component placement for ITE hearing instruments. Advanced automatic protocols are advantageous over manual protocols because they increase the quality of the ITE shell, allow for production time saving, and permit moving the shell modeling, detailing and component placement to the front-end of the process. The present invention can be integrated into other higher-level systems.

The procedure defines the automatic protocols for automation of modeling, detailing and component placement of ITE shells, including the following categories described in more detail below: a) general rules; detailing rules for b) ITE, c) HS, d) CA, e) MC, f) CIC designs; g) rules for the receiver hole and vent; h) rules for component placement; and i) rules for collision detection.

### DESCRIPTION OF THE DRAWINGS

The invention is explained by the following drawings and appertaining descriptive text below, which are illustrative of various embodiments of the invention.
- Figure 1: is a block flow diagram illustrating a basic system overview of a Phase II implementation of rule-based binaural detailing and modeling;
- Figure 2: is a block diagram illustrating cutting and detailing operations with required features that need to be feature recognized in order to accomplish the pertinent detailing operation;
- Figure 3: is a 3D generated model illustrating an initial plane cut for all shells;
- Figure 4: is a 3D generated model illustrating the transparent part of the shell that is the lower intertragal notch;

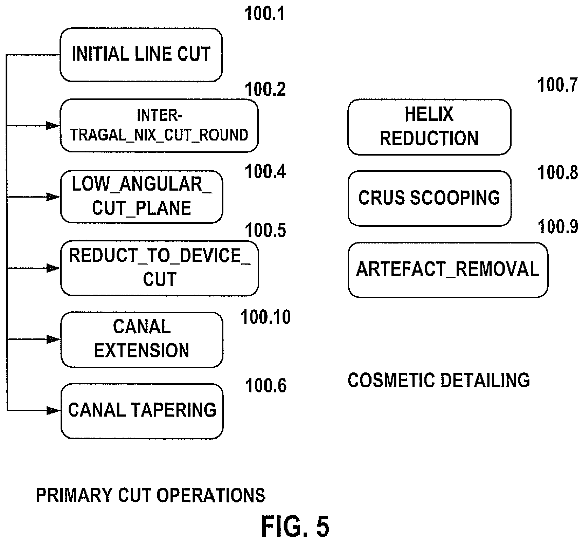

- Figure 5: is a block diagram illustrating rule-based cuts and configurable cosmetic protocols for ITEs;
- Figure 6: is a block diagram illustrating rule-based cuts for HSs;
- Figure 7: is a 3D generated model illustrating a standard cut for CICs, MCs, CAs, and HSs (Crus_Cut_Round);
- Figure 8: is a 3D generated model illustrating a Low_Angular_Cuts_Plane and shell Reduce_to_Device_Cut;
- Figure 9: is a block diagram illustrating rule-based cuts for CICs;
- Figure 10: is a pictorial diagram illustrating a receiver and vent channel configurations on a typical CIC and ITE shells;
- Figure 11: is a pictorial block diagram illustrating reactional forces resulting from component interaction within the shell; and
- Figures 12A-F: are pictorial illustrations of faceplate orientations in various shell types.
- Figure 13: is a pictorial illustration showing the battery door;
- Figure 14A: is a pictorial illustration of a shell without an IROS cut;
- Figure 14B: is a pictorial illustration of a shell with an IROS cut;
- Figure 15A: is a pictorial illustration of a receiver and shell colliding;
- Figure 15B: is a pictorial illustration of a receiver and shell that are avoiding a collision;
- Figure 16: is a pictorial illustration of a shell in process "sitting" in a virtual cast;
- Figure 17A: is a pictorial illustration of a push button;
- Figure 17B: is a pictorial illustration of a volume control;
- Figure 18: is a pictorial illustration of an alternate for canal cutting; and
- Figures 19A, B: are pictorial illustrations of an impression oriented so that the helix, concha, and canal openings are at a consistent height and parallel to the base of the impression.

### DETAILED DESCRIPTION OF THE PREFERRED EMBODIMENTS

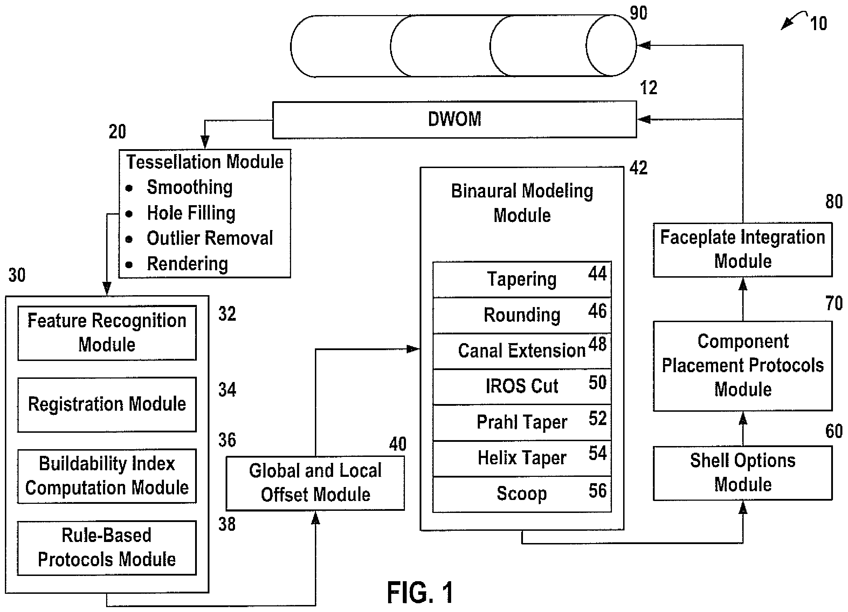

Figure 1 presents an overview of the system 10. The present system 10 identifies characteristic features of the ear canal and defines rule based protocols for designing custom hearing aid for the patient. The flow begins with a work order for a hearing aid stored in a digital work order management system DWOM 12 (this system serves as an interface between modeling/detailing software and the business systems, defining the communications protocol) in which digitized 3D shell feature data is subjected to a tessellation module 20 that performs smoothing, hole filling, outlier removal, and rendering based on the shell model.

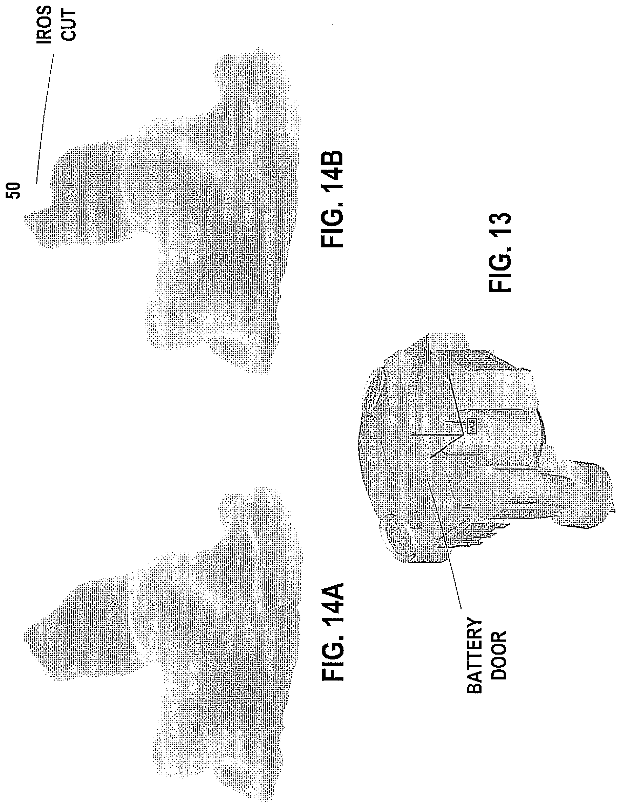

The shell is then subjected to an analysis procedure 30 that includes feature recognition 32, a registration of features 34, a buildability index computation (BIA) implementation 36 as well as rule-based protocol handling 38. Data is then provided to a global and local offset module 40 and the data is then subjected to binaural processing 42 to augmented detailing and modeling protocols, such as tapering 44, rounding 46, canal extension 48, and IROS cut 50. Figure 14A illustrates a shell without an IROS cut, and Figure 14B illustrates a shell with an IROS cut. The IROS cut creates a step-like structure on the shell tip. This is used, e.g., to create an impression at the customer site in which the vent inlet on the tip side is bigger than it is in reality. This cut also provides certain audiological advantages. The augmented detailing protocols may further include the Prahl taper 52, helix taper 54, and scoop 56. A more detailed explanation of these procedures may be found in the pending patent application listed in the opening paragraph of this application.

A shell options module 60 allows the user to configure a number of parameters associated with the shell and store them. A further module, the component placement protocols module 70, assists in placing the components and ensuring that collisions do not take place. Finally, a faceplate integration module 80 is provided in order to assist in the proper placement of faceplates. Data from the completed design is the stored in a database 90 that includes the finalized shell information.

The procedure defines the automatic protocols for automation of modeling, detailing and component placement of ITE shells, including the following categories described in more detail below: a) general rules; detailing rules for b) ITE, c) HS, d) CA, e) MC, f) CIC designs; g) rules for the receiver hole and vent; h) rules for component placement; and i) rules for collision detection.

### A) GENERAL RULE-BASED REQUIREMENTS

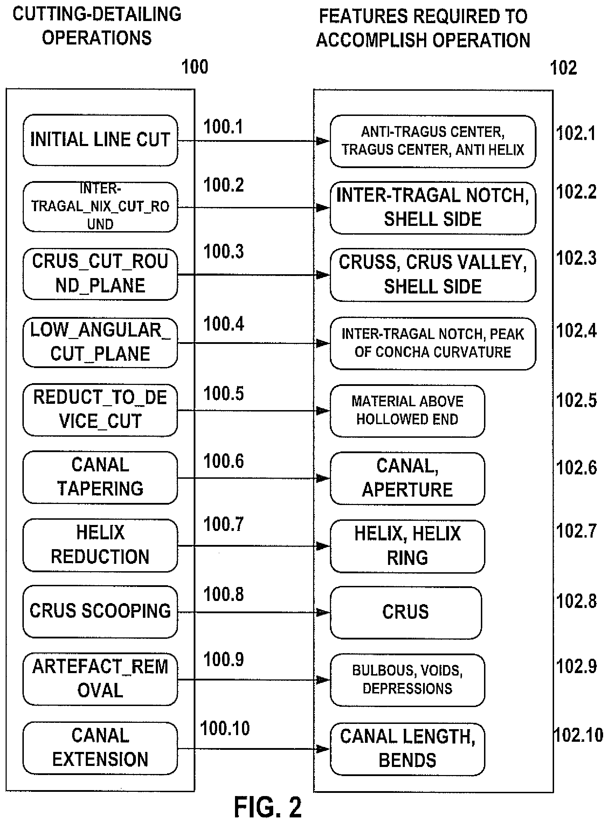

Software modules on the system detect, extract, and measures all essential features that are required for primary cuts, and listed in Figure 2. Impressions are detailed based on the prescribed device type, and the appertaining rules for modeling each device type are defined in the following sections. The software combines line cuts with associated cosmetic detailing protocols, and it performs canal extension, tapering and rounding based on prescribed preferences parameters for device type. The aperture of the impression can be used as the initial starting point for extension, tapering and rounding.

The software places components into the shell based on rules associated with device type. In CICs, MC, and CA types, an insert module is placed such that the battery door is below the aperture line. All receivers are placed as close as possible to the canal tip, and the shell height can be reduced based on where a collision occurs between the electronic components associated with the faceplate, receiver suspension, and floating hybrid components.

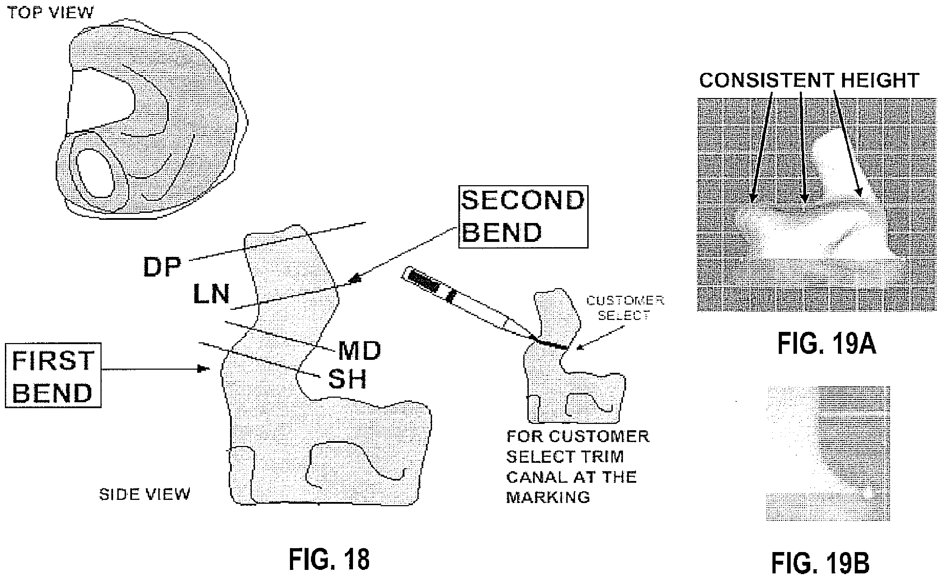

The placements of components is based on recognized device features and business logic. A specific orientation exists for faceplate placement. For instance, in full shells, faceplate orientation is such that the battery door opens towards the tragus. Secondly, identified landmarks on the shell indicate the preliminary height of the device. Referring to Figures 19A and 19B, in an embodiment, the impression is oriented so that the helix, concha, and canal openings are at a consistent height and parallel to the base of the impression-a plane is defined through the base of the impression. Ideally, the plane cuts the impression approximately 2mm down from the center of the flares of the tragus, anti-tragus, and helix towards the base of the impression. When real estate is still available in the shell based on collision verification, the software lowers the shell further.

Collision verification, avoidance, and final assembly are based on sequentially defined rules: all detailing cuts can be executed automatically by the software; components are placed such that there is a minimum distance ("Minimum Distance Configurable") between components; and components can be lowered further towards the canal end of the shell (along the centerline) if there is more real estate after the preliminary component placement.

The system software has the ability to dynamically load and execute device based rules. Routines for modeling device types can be loaded as part of an Instrument Model Options in DWOM, and the software can display the device type being modeled using DWOM protocols.

The system software can dynamically place electronic components based on assigned rules for the device type. The initial receiver placement is below the aperture and above the canal tips, and the location of the receiver in each device type is configurable. The faceplate placement and orientation are configurable per device type, and the placement takes into account unique device features. The faceplate orientation per device and the maximum allowable shell height are configurable as well. The software is able to place vent and receiver holes based on device types, and the faceplate placement and merge are based on pre-defined rules for the device type.

All line cuts and corresponding features required to rule detail impressions are shown in Figure 2. The system allows the user to make minor angle adjustments for primary and cosmetic cuts, but in an embodiment of the invention, there is no user intervention required. Accordingly, Figure 2 shows the cutting-detailing operations 100 and the corresponding features 102 required to accomplish an appertaining cutting-detailing operation 100.

The initial line cut 100.1 requires information pertaining to the anti-tragus center, tragus center, and anti helix 102.1. The intertragal nix cut round 100.2 requires information pertaining to the intertragal notch and the shell side 102.2. The crus cut round plane 100.3 requires information related to the crus, curs valley, and shell side 102.3. The low angular cut plane 100.4 requires information related to the intertragal notch, and the peak of the concha curvature 102.4. The reduct to device cut 100.5 requires information about material above the hollowed end of the device 103.5.

Canal tapering 100.6 requires information about the canal and the aperture. A tapering of canals 8mm or longer is performed on ST, HS, and CA models only (i.e., more than 8mm from the low of the aperture to the cut line on the canal). A tapering of canals shorter than 8mm (ST, HS, and CA, i.e., less than 8mm from the lower of the aperture to the cut line on the canal) makes use of an extended taper. The canal width after the taper is applied should be no more than approximately 2mm larger than the narrowest area of the aperture.

The helix reduction 100.8 requires information about the helix and the helix ring. The crus scooping 100.8 requires information pertaining to the crus. The artifact removal 100.9 requires information about bulbous regions, voids, and depression 102.9. Finally, the canal extension 100.10 requires information about the canal length and bends 102.10. In a preferred embodiment, the maximum allowed extension is 2mm. To achieve this, a plane is defined on the canal tip perpendicular to the direction of required extension, and the extension is performed, with a test to ensure that the canal does not extend at an incorrect angle based on the first and second bend areas. This list covers the primary cuts, but is in no way exhaustive as to the information that can be associated with other cuts as well.

### B) DETAILING RULES FOR FULL SHELL (ITE)

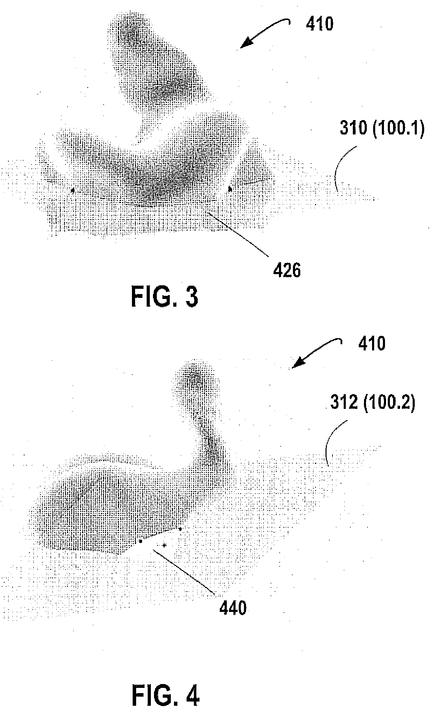

As illustrated in Figure 3, and according to the detailing rules for a full shell ITE device, the system software inserts an initial cutting contour 310 (100.1) at the center of the tragus (not shown), the center of the anti-tragus (not shown), and the anti-helix 426. As is illustrated by Figure 3, where the transparent region is removed by this cut operation; this is a standard cut for *all* devices. The software automatically removes all material below the hollowed end of the shell 410, and recognizes and removes the lower end of the intertragal notch 440 (100.2), as illustrated by Figure 4; this is usually removed to reduce painful insertion for the patient. The degree of rounding of the intertragal notch can be configurable.

The system software automatically trims the canal using the following criteria: the canal length is determined from the aperture to the canal tip, and the canal length is configurable for, e.g., "Small," "Medium" (default) and "Large". The software can taper the canal based on, e.g., "Long", "Medium", and Short. The following table illustrates configurations in a preferred embodiment of the invention.

**Table 1**

| *Configuration Table with Values* | | |
|---|---|---|
| Parameter Name | Strength | Value |
| Tapering | Small | 0.06 |
| | Medium | 0.08 |
| | Large | 0.10 |
| Canal Length | Small | 0.1 |
| | Medium | 0.2 |
| | Large | 0.3 |
| Rounding | Small | 0.06 |
| | Medium | 0.08 |
| | Large | 0.10 |
| Prahl Tapering | Small | 1 |
| | Medium | 2 |
| Helix Tapering | Small | 1 |
| | Medium | 2 |

Figure 18 illustrates an alternative for canal cutting, in which a canal length is specified either by market specific requirements or by a customer specified length. As illustrated, the cut can be made just after the first bend (SH), between the first and second bend (MD), at the second bend (LN), and after the second bend (DP). If a bell bore is selected, then in an embodiment, the canal is cut 2mm longer than the specified line cut. CIC models should generally always be cut 2-4mm past the second bend. For all canal cutting, the system should ensure a binaural match for: the canal length, the canal tip shape, and the canal cut plane (i.e., the resulting canal tip shape should be similar on both sides).

The system software can automatically extend the canal according to the following criteria: the canal length is determined from the aperture to the canal tip, and may be configurable for, e.g., "Small", "Medium" (default), and "Large". The software can taper the canal based on, e.g., three configurable levels: "Long", "Medium", and "Short". The tapering starts from the aperture and the optimum direction is normal to the centerline plane at the second bend. Using a buildability index computation algorithm 36, the software can determine whether a canal extension or tapering is required.

The system software detects and reduces the helix length (100.7), which is configurable as, e.g., "Medium", "Small", and "Remove". The software can provide two additional options or attributes to determine whether the helix should be preserved or not: "Preserve Helix" and "Remove Helix". Faceplate lowering can be used to optimize and finalize the shell height. The requirements on rule based component placement are defined in subsequent sections.

### C) DETAILING RULES FOR HALF SHELL (HS)

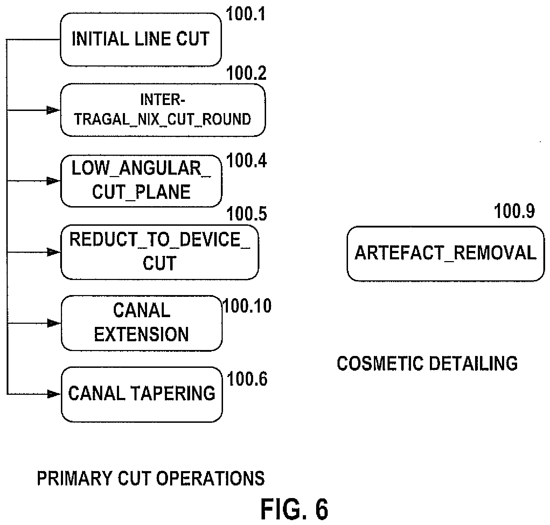

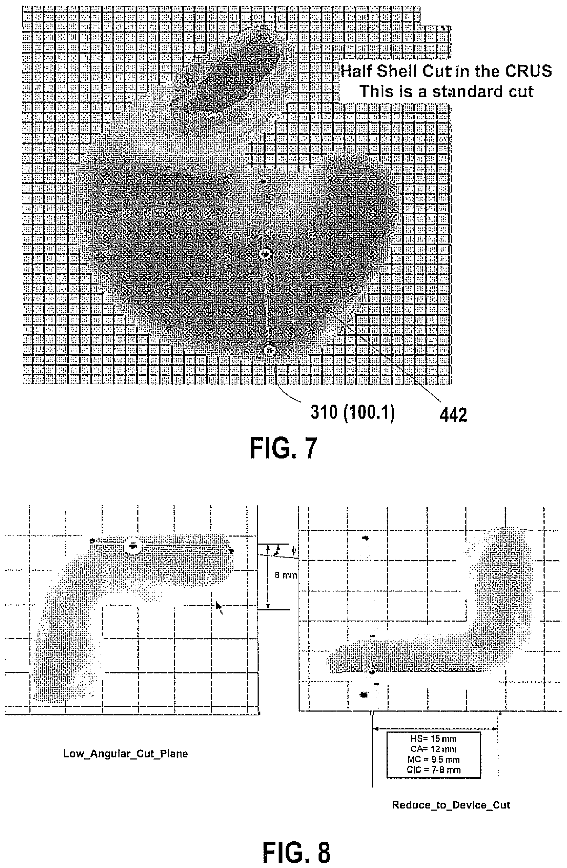

The basic steps for modeling HS shells are shown in Figure 6. According to he detailing rules for a half shell HS device, the requirements are as follows. Referring to Figures 6 and 7, the system software can identify and remove the concha of the impression (Reduct_to_Device_Cut 100.5) by inserting a cutting plane 310 along the crus; the crus can be eliminated using a configured level of a Rounding-Crus_Cut_Round_Plane.

The software can measure the distance from the center of the tragus to the concha. The minimum dimension for a half-shell measure from the tragus to the concha can be configurable as a shell width; all material beyond the shell width is preferably removed with a configured rounding

A Low_Angular_Cut (100.4) can be inserted at a configurable angle (the "cut angle") from the inter-tragal notch to intersect a perpendicular line from the concha peak to the angular plane; the optimal shell height from the concha peak to the angle plane can be configurable as the concha height.

### D) DETAILING RULES FOR CANAL (CA)

According to he detailing rules for a canal CA device, the system software identifies all the features required to detail a canal (shown in Figure 2). The software recognizes and removes the concha of an impression by inserting the cutting plane along the crus using a configured level of rounding-the Crus_Cut_Round Plane 100.3, which is shown in Figure 7. The software measures the distance from the center of the tragus to the mid-concha curvature. The minimum dimension for a canal is configurable as the shell width (specified in, e.g., mm); all material behind the shell width 442 is removed with a configurable level of rounding. If the measured distance is less than the shell width, the software can display an error message, such as, "Insufficient materials; specified device type cannot be built."

A Low_Angular_Cut 100.4 can be initiated at the inter-tragal notch and the concha curvature peak; the angular value can be configurable in the preferences table for each device type. The optimal shell height from the concha peak to the angle plane can be configurable as the concha height. Figure 8 illustrates the Low_Angular_Cuts_Plane 100.4 and the shell Reduce_to_Device_Cut 100.5.

### E) DETAILING RULES FOR MINI CANAL (MC)

According to the detailing rules for a mini-canal MC device, the system software identifies and removes the concha of the impression by inserting a cutting plane along the crus-the Crus_Cut_Round_Plane 100.3, with the level of rounding being configurable, as is illustrated in Figure 7. The software measures the distance from the center of the tragus to the concha, and the minimum dimension for a mini-canal can be configurable as the shell width. All material behind the configured shell width 442 may be removed with a configured rounding. A Low_Angular_Cut 100.3 can be inserted at a configured angle (the cut angle) from the inter-tragal notch and the concha curvature peak. The optimal shell height from the concha peak to the angle plane can be configurable as the concha height.

All electronic components are placed based on the device rules: the faceplate is placed on the resulting impression from the rule based cuts; the faceplate is lowered until a collision occurs with the internal components or the shell, and the faceplate plane can be used to finalize the shell lowering. The receiver is placed close to the canal and below the aperture; the distance from the tip should be configurable as well. This is discussed in more detail below.

### F) COMPLETELY-IN-THE-CANAL (CIC)

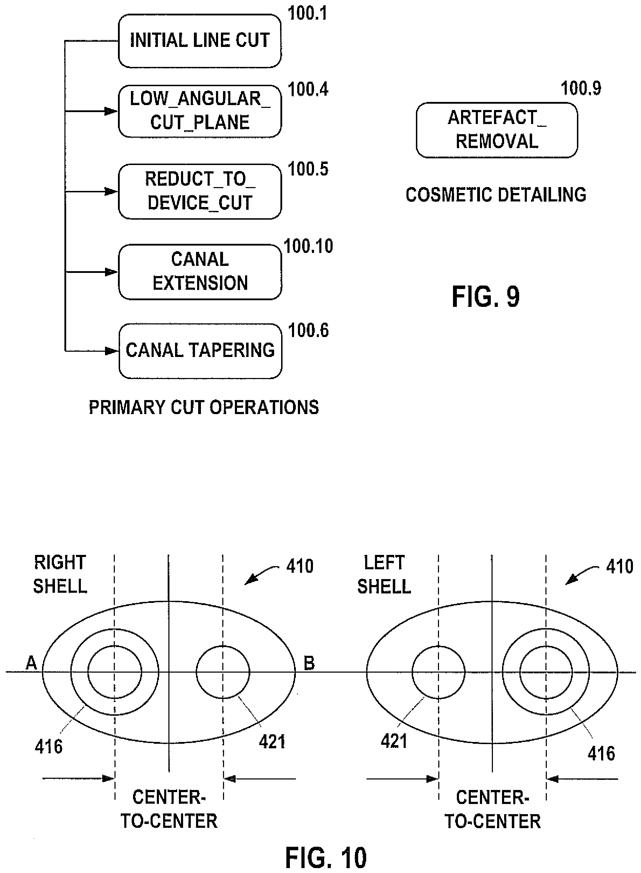

Referring to Figure 9, according to the detailing rules for a completely-in-the-canal CIC device, the CIC requirements can be implemented using the following approaches: for the low angular cut plane 100.4, the aperture plane is oriented at a configured angle (cut angle) to the centerline direction; all material below the aperture is removed. The canal length from the aperture to the canal tip is configured as the shell height, and the canal is extended along the centerline by a configurable value (the canal extension 100.10). If the canal is longer than the configurable values, it is automatically trimmed and tapered by a configurable value (the canal tapering 100.6).

A receiver is placed at a configured distance from the canal tip, and the faceplate is placed and lowered with collision verification of the electronics module with the shell and other components (discussed below).

### G) RULES ON RECEIVER AND VENT HOLES

Figure 10 illustrates a receiver hole 421 and vent configuration 416 on an elliptical canal tip. The software determines that, for CIC and ITE designs, the vent 416 and receiver channel 421 configurations are fixed as shown. In CIC and ITE designs, all vents follow a defined contour from the canal tip along the intertragal notch. The receiver hole 421 is drilled along the crus side of the canal, with the receiver 421 and vent channels 416 being equidistant from the sides of the impression canal and centered at the foci of the canal ellipse. (See Figure 10 (A-B)).

However, the software determines that, for HS, CA, and MC designs, the vent 416 and receiver 421 channel configurations are interchanged (i.e., are the reverse of what is shown in Figure 10). For directional shells, the software determines that the receiver 421 and vent 416 configuration are the same as that for CIC and ITE designs. (See Figure 10).

These rules have certain exceptions: when a venting channel 416 is not explicitly specified, the receiver channel 421 is placed at the center of the canal, and for CIC designs, the vent is re-oriented when there is insufficient real estate.

Various shell options can also be implemented. For example, the shell wall thickness can have various configurable options. An option for a variable wall thickness is provided, for example, the system may provide for an adaptive wall thickness in high curvature regions. Variable thickness may be defined as a percent increase of the uniform wall thickness specification in a user configurable preferences database which may, e.g., be accessed via a displayed tab. Alternative variable thickness algorithms can be implemented with a polynomial function. However, the software can provide an option for specifying a uniform wall thickness (a default wall thickness). Furthermore, the software can provide an option for the application of selective wall thickness to a specified area of the shell-this region may be selectable by the user who may use, e.g., a lasso selection tool as is known in the graphical arts. A further capability of the software may be allowing empty areas of the shell to be filled with material.

The software is designed to place the receiver hole on the correct side of the impression (left or right) using feature recognition (FR) protocols which identify different pre-defined areas of the shell such as helix, tragus, aperture etc. FR also can identify the canal and tip of the impression. By knowing the location of the tip of the impression, the software can automatically position the receiver hole on the left or on the right side of the tip, depending on the instructions for the specific shell type.

With regard to vent generation, the software is designed to define vent location and orientation, and to allow control of the vent placement and the specification of the location of vents based on a particular device type. The software ensures the placement of vents based on whether an impression is identified as left and right ear impression. Furthermore, the software may provide an enable/disable function, via, e.g., check boxes of the user interface, in a user interface area associated with vent options (e.g., a vent tab under a preferences area), as well as in a user interface area in the "modeling" flow step for simulation vent placement. When the vent feature is enabled, a virtual vent is shown to the user in the user interface. The vent simulation considers the available space in the shell, and the vent generation takes into consideration the presence of components and possible interaction with components. In a preferred embodiment, a collision between vents and shell components may be highlighted-the software thus allows collision detection with components to take into account the presence of the vent. The user can change the vent type based on a prior database configuration, and modified vent types and options can be written to the database DB. The system allows the selection of both vent type and styles.

Furthermore, the vent wall thickness can be configurable for all device types, and the level of component penetration of electronic components into the vent wall is configurable as, e.g., a numerical value; this configuration parameter can be associated with the other vent configuration parameters and presented to the user under, e.g., the displayed vent tab. Additionally, the collision display for the colliding triangles can be configured in a different color (e.g., via a user display color tab).

### H) DYNAMIC COMPONENT PLACEMENT

The software ensures that colliding components are placed at a configurable distance from nearest neighbors-this is essentially a self-correcting interference mechanism for collision. Colliding components within the shell shall have the ability to self-align to offset collision, and a feedback mechanism allows device size optimization .

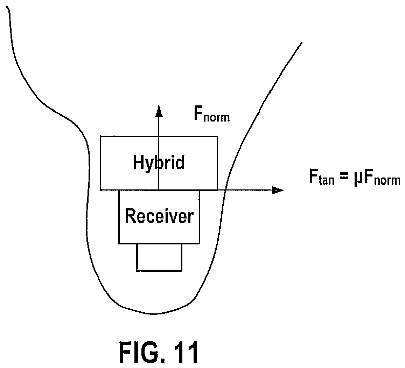

Electronic components can be lowered further into the shell as long as the resulting contact forces in a z-direction do not exceed a configurable maximum normal force value (see Figure 11, illustrating reactional forces resulting from component interaction within the shell). The allowable maximum normal force can be configurable as a parameter MAX-Normal-Force in the user-configurable preferences.

### Receiver Placement

The software can automatically place the receiver at the canal tip, in accordance with the following criteria. The receiver snout is positioned from the canal tip on a configurable canal-receiver snout distance. The top of the receiver is placed such that its width is aligned to a major axis of the nearest shell ellipse. The center of the ellipse is at the center of the receiver geometry, and the receiver is placed below the aperture line. However, if the receiver does not fit below the aperture, it is then positioned as low as possible. Double receivers are usually too large to fit into the canal, and thus, these are usually allowed to sit above the aperture.
Collision detection is ideally enabled for all geometric component and new surfaces created, e.g. integrated faceplate surfaces, gluing surfaces, and suspensions.

### Automatic Faceplate Placement and Integration

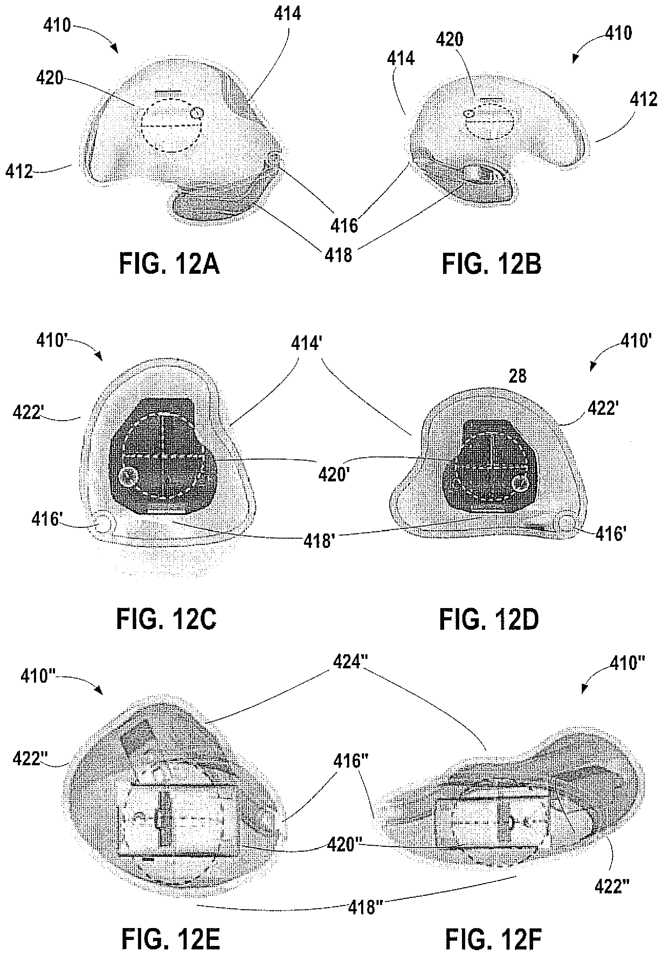

Figures 12A-F illustrate faceplate orientation according to different shell types. Figures 12A and 12B illustrate a full shell (FS) design. Figures 12C and 12D illustrate half shell (HS), canal (CA), and mini-canal (MC) designs. Finally, Figures 12E and 12F illustrate a completely-in-canal (CIC) design. Each of the figures illustrate the location of various features of the hearing aid shell 10 (note that reference characters are prime in Figures 12C and 12D, and double-prime in Figures 12E and 12F-use of the reference character without the corresponding prime marks is intended to be inclusive, where appropriate). Accordingly, the features of the helix 412, anti-tragus 414, vent 416, tragus 418, microphone 420, crus 422, and concha bowl 424 can be seen.

### Battery Door Placement

For an in-the-ear (ITE) device, the battery door (Figure 13) is positioned such that it opens away from the tragus 418. But for HS, CA and MC designs, the battery door is positioned such that it opens towards the tragus 418. In the CIC design, the battery door is positioned so that it opens away from the vent hole 416.

### 1) COLLISION DETECTION

The software is designed to ensure that collision detection is facilitated between the merge surfaces and the components according to the following algorithm:

1) Surface triangles are extracted to form a separate Stereolithography Tessellation Language(STL) file that represents a merge surface of the shell.

2) Every part of the merge surface STL and each component is compared as to whether they intersect.

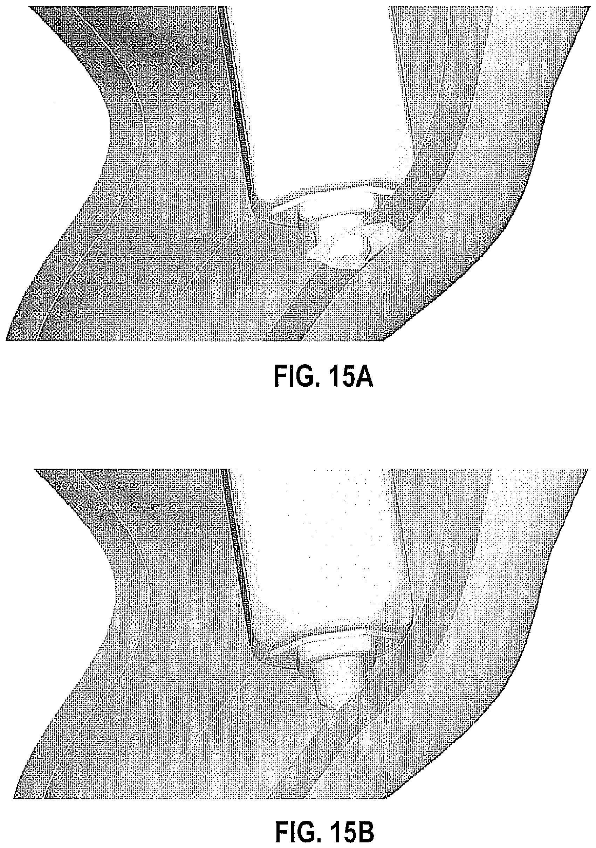

3) If any of the components and merge surface STL intersect, then a collision is reported (Figure 15A). Otherwise no collision is reported (Figure 15B).

This may be achieved with the user of a display to the user and related processing software, as illustrated in Figures 15A, B. These Figures illustrate the shell which is clipped by the clipping plane to see the inside of the shell. In Figure 15A, the receiver collides with the shell, and the receiver may, e.g., be shown in red and the area where collision happens in yellow. On Figure 15B, no collision occurs and faceplate may, e.g., be drawn in green. This permits rapid feedback to the user of the system.

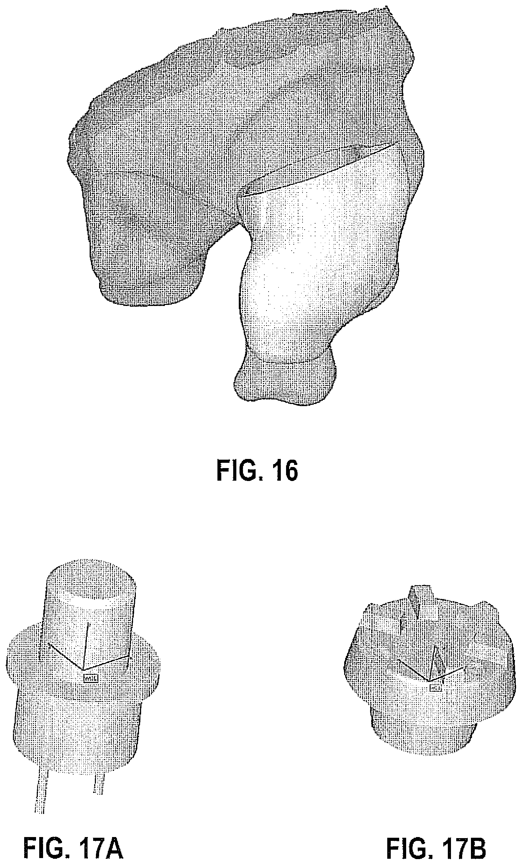

The software detects and may display all colliding triangles based on, e.g., a configurable color in a preferences table that can be modified by a user (or any other graphical tool that could serve to highlight a collision. This collision detection is enabled between:
- the shell and all internal and external interacting components;
- the faceplate/faceplate options and a virtual cast (VC) (the virtual cast is the original undetailed impression which represents the reference point to the human ear during modeling and detailing. Technicians often check during their modeling and detailing work to see how the shell "sits" in the virtual cast. If for any reason the faceplate or faceplate options collide with the virtual cast, this means that in real life, the faceplate or the faceplate options will hurt the ear of the patient because of protrusions and discontinuities. A display of a the shell sitting within the virtual cast can be seen in Figure 16;
- optional components, such as a push button PB (Figure 17A) or a volume control VCtl (Figure 17B); and
- the faceplate.

For each of these three, a user-interface element, such as a check box, can enable and disable collision detection, but, in a preferred embodiment, the default value for detection would be "true". In order to facilitate operation, all of the electrical components can have a configurable color to make them easy to visualize by the user.

For the purposes of promoting an understanding of the principles of the invention, reference has been made to the preferred embodiments illustrated in the drawings, and specific language has been used to describe these embodiments.

The present invention may be described in terms of functional block components and various processing steps. Such functional blocks may be realized by any number of hardware and/or software components configured to perform the specified functions. For example, the present invention may employ various integrated circuit components, e.g., memory elements, processing elements, logic elements, look-up tables, and the like, which may carry out a variety of functions under the control of one or more microprocessors or other control devices. Similarly, where the elements of the present invention are implemented using software programming or software elements the invention may be implemented with any programming or scripting language such as C, C++, Java, assembler, or the like, with the various algorithms being implemented with any combination of data structures, objects, processes, routines or other programming elements. Furthermore, the present invention could employ any number of conventional techniques for electronics configuration, signal processing and/or control, data processing and the like.

## Claims

1. A method for designing and building a hearing aid, comprising:
receiving (12) a work order for a hearing aid which includes a digitized 3D shell model;
performing (20) at least one of smoothing, hole filling, outlier removal, and rendering based on the shell model;
analyzing (32) the shell model to recognize features and determine relevant parameters associated with the features;
registering and storing (34), in a data store, the recognized features and associated parameters;
implementing (38) a rule-based protocol handling for the shell model that is determined based on a chosen shell type;
performing (40) global and local offsets on data associated with the shell model; performing (42) binaural processing to augmented detailing and modeling protocols used on the shell model; and
creating a hearing aid based on the shell model processed according to the preceding steps.

2. The method according to claim 1, wherein the augmented detailing and modeling protocols include tapering, rounding, and canal extension.

3. The method according to claim 1, wherein the rule-based protocol handling determines component placement.

4. The method according to claim 1, further comprising configuring a number of parameters associated with the shell and storing them.

5. The method according to claim 1, further comprising assisting placing components and ensuring that collisions do not take place that is dependent on the device type.

6. The method according to claim 1, further comprising assisting placing a faceplate on the hearing aid shell.

7. The method according to claim 1, further comprising determining a buildability index for the shell model.

8. The method according to claim 1, further comprising automatically performing detailing cuts on the shell model.

9. The method according to claim 1, further comprising placing components such that there is a minimum acceptable distance between the components.

10. The method according to claim 1, further comprising dynamically loading and executing device-based rules depending on a device type.

11. The method according to claim 1, further comprising placing electronic components based on assigned rules for the device type.

12. The method according to claim 1, further comprising providing a user interface permitting for manual minor angle adjustments for primary and cosmetic cuts.

13. The method according to claim 1, wherein the processing comprises performing an initial line cut, an intertragial nix cut round, crus cut round plane, low angular cut plane, reduct to device cut, canal tapering, helix reduction, crus scooping, artifact removal, and canal extension.

14. The method according to claim 1, wherein, for an in-the-ear (ITE) device, the processing comprises:
inserting an initial cutting contour at a center of a tragus, a center of an anti-tragus, and an anti-helix;
removing all material below a hollowed end of the shell; and
recognizing and removing a lower end of the intertragal notch.

15. The method according to claim14, further comprising:
categorizing an attribute in a plurality of size categories; and
associating a value with the attribute size category; and
using the associated value in performing the tapering, length and rounding operations.

16. The method according to claim 1, wherein, for a half shell hearing aid (HS) device, the processing comprises performing an initial line cut, an intertragial nix cut round, low angular cut plane, reduct to device cut, canal extension, and canal tapering.

17. The method according to claim 1, wherein, for a canal hearing aid (CA) device, the processing comprises:
identifying all features required to detail a canal;
recognizing and removing a concha by inserting a cutting plane along a crus using a predetermined configured level of rounding;
performing a low angular cut initiated at an inter-tragal notch and concha curvature peak.

18. The method according to claim 1, wherein, for a mini canal hearing aid (MC) device, the processing comprises:
identifying and removing a concha by inserting a cutting plane along a crus, with a predetermined configurable level of rounding;
removing all material behind a configured shell width a configured rounding;
inserting a low angular cut at a predetermined configured angle from an inter-tragal notch and concha curvature peak;
lowering a faceplate until just before a collision occurs with internal components or shell; and
placing a receiver close to a canal and below an aperture at a predefined configurable distance from a tip of the canal.

19. The method according to claim 1, wherein, for a completely-in-canal (CIC) device, the processing comprises:
performing an initial line cut, a low angular cut plane, reduct to device cut, canal extension, and canal tapering, wherein for the low angular cut plane, the processing comprises orienting an aperture plane at a predetermined configured angle to a centerline direction and removing all material below the aperture, configuring a canal length from the aperture to a canal tip as the shell height, and extending the canal along a centerline by a predetermined configurable value, and placing a receiver at a predetermined configurable distance from the canal tip.

20. A computer readable media comprising software algorithms of computer-readable code that can be executed on a processor, the algorithms comprising:
an algorithm for entering a work order for a hearing aid which includes a digitized 3D shell model having feature data;
an algorithm for performing at least one of smoothing, hole filling, outlier removal, and rendering based on the shell model;
an algorithm for analyzing the shell model to recognize features and determine relevant parameters associated with the features;
an algorithm for registering and storing, in a data store, the recognized features and associated parameters;
an algorithm for implementing a rule-based protocol handling for the shell model that is determined based on a determined shell type;
an algorithm for performing global and local offsets on data associated with the shell model; and
an algorithm for performing binaural processing to augmented detailing and modeling protocols used on the shell model.

## Patentansprüche

1. Verfahren zum Entwerfen und Herstellen einer Hörhilfe, das Folgendes umfasst:
Empfangen (12) eines Arbeitsauftrags für eine Hörhilfe, die ein digitalisiertes 3D-Hüllenmodell enthält;
Ausführen (20) eines Glättens und/oder Lochfüllens und/oder Ausreißerentfernens und/oder "Renderings" anhand des Hüllenmodells;
Analysieren (32) des Hüllenmodells, um Merkmale zu erkennen und relevante Parameter zu bestimmen, die den Merkmalen zugeordnet sind;
Registrieren und Speichern (34) in einem Datenspeicher der erkannten Merkmale und zugeordneten Parameter;
Implementieren (38) einer auf Regeln beruhenden Protokollbearbeitung für das Hüllenmodell, die anhand eines gewählten Hüllentyps bestimmt ist;
Ausführen (40) von globalen und lokalen Versetzungen an Daten, die dem Hüllenmodell zugeordnet sind;
Ausführen (42) einer binauralen Verarbeitung an verbesserten Detaillierungs- und Modellierungsprotokollen, die an dem Hüllenmodell verwendet werden; und
Erzeugen einer Hörhilfe anhand des gemäß den vorhergehenden Schritten verarbeiteten Hüllenmodells.

2. Verfahren nach Anspruch 1, wobei die verbesserten Detaillierungs- und Modellierungsprotokolle ein Abschrägen, ein Runden und eine Gangverlängerung enthalten.

3. Verfahren nach Anspruch 1, wobei die auf Regeln beruhende Protokollbearbeitung eine Komponentenplatzierung bestimmt.

4. Verfahren nach Anspruch 1, das ferner umfasst, eine Anzahl von Parametern zu konfigurieren, die der Hülle zugeordnet sind, und sie zu speichern.

5. Verfahren nach Anspruch 1, das ferner umfasst, beim Platzieren von Komponenten zu helfen und zu gewährleisten, dass keine Kollisionen auftreten, die von dem Vorrichtungstyp abhängen.

6. Verfahren nach Anspruch 1, das ferner umfasst, das Platzieren einer Gesichtsplatte auf der Hörhilfehülle zu unterstützen.

7. Verfahren nach Anspruch 1, das ferner umfasst, einen Baubarkeitsindex für das Hüllenmodell zu bestimmen.

8. Verfahren nach Anspruch 1, das ferner umfasst, automatisch Detaillierungsschnitte an dem Hüllenmodell auszuführen.

9. Verfahren nach Anspruch 1, das ferner umfasst, Komponenten derart zu platzieren, dass zwischen den Komponenten ein minimaler zulässiger Abstand vorhanden ist.

10. Verfahren nach Anspruch 1, das ferner umfasst, auf der Vorrichtung beruhende Regeln abhängig von einem Vorrichtungstyp dynamisch zu laden und auszuführen.

11. Verfahren nach Anspruch 1, das ferner umfasst, elektronische Komponenten anhand von zugeteilten Regeln für den Vorrichtungstyp zu platzieren.

12. Verfahren nach Anspruch 1, das ferner umfasst, eine Anwenderschnittstelle bereitzustellen, die manuelle kleinere Winkelanpassungen für primäre und kosmetische Schnitte erlaubt.

13. Verfahren nach Anspruch 1, wobei das Verarbeiten ferner umfasst, einen Anfangslinienschnitt, einen intertragalen "Nix cut round", eine Crus-"Cut round"-Ebene, eine tiefe schräge Schnittebene, einen "Reduct to device"-Schnitt, ein Gangabschrägen, eine Helix-Verringerung, ein Crus-Ausschöpfen, eine Artefaktentfernung und eine Gangverlängerung auszuführen.

14. Verfahren nach Anspruch 1, wobei für eine ohrinterne Vorrichtung (ITE-Vorrichtung) das Verarbeiten Folgendes umfasst:
Einfügen eines Anfangsschnittumrisses an einem Mittelpunkt eines Tragus, einem Mittelpunkt eines Antitragus und einem Antihelix;
Entfernen jeglichen Materials unter einem ausgehöhlten Ende der Hülle; und
Erkennen und Entfernen eines unteren Endes der intertragalen Kerbe.

15. Verfahren nach Anspruch 14, das ferner Folgendes umfasst:
Kategorisieren eines Attributs in mehrere Größenkategorien; und
Zuordnen eines Wertes zu der Attributgrößenkategorie; und
Verwenden des zugeordneten Wertes beim Ausführen des Abschrägens, der Länge- und Rundungsvorgänge.

16. Verfahren nach Anspruch 1, wobei für eine Halbschalenhörhilfevorrichtung (HS-Vorrichtung) das Verarbeiten umfasst, einen Anfangslinienschnitt, einen intertragalen "Nix cut round", eine tiefe schräge Schnittebene, einen "Reduct to device"-Schnitt, eine Gangverlängerung und ein Gangabschrägen auszuführen.

17. Verfahren nach Anspruch 1, wobei für eine ganginterne Hörhilfevorrichtung (CA-Vorrichtung) das Verarbeiten Folgendes umfasst:
Identifizieren aller Merkmale, die benötigt werden, um einen Gang zu detaillieren;
Erkennen und Entfernen einer Ohrmuschel durch Einfügen einer Schnittebene entlang eines Crus unter Verwendung eines vorgegebenen konfigurierten Rundungsausmaßes;
Ausführen eines tiefen schrägen Schnitts, der an einer intertragalen Kerbe und einem Ohrmuschelkrümmungsspitzenwert beginnt.

18. Verfahren nach Anspruch 1, wobei für eine ganginterne Minihörhilfevorrichtung (MC-Vorrichtung) das Verarbeiten Folgendes umfasst:
Identifizieren und Entfernen einer Ohrmuschel durch Einfügen einer Schnittebene entlang eines Crus mit einem vorgegebenen konfigurierbaren Rundungsausmaß;
Entfernen jeglichen Materials hinter einer konfigurierten Hülle mit einem konfigurierten Runden;
Einfügen eines tiefen schrägen Schnitts in einem vorgegebenen konfigurierten Winkel von einer intertragalen Kerbe und einem Ohrmuschelkrümmungsspitzenwert;
Senken einer Gesichtsplatte bis gerade bevor eine Kollision mit internen Komponenten oder der Hülle auftritt; und
Positionieren eines Empfängers in die Nähe eines Gangs und unter eine Öffnung in einem vordefinierten konfigurierbaren Abstand von einer Spitze des Gangs.

19. Verfahren nach Anspruch 1, wobei für eine vollständig gehörganginterne Vorrichtung (CIC-Vorrichtung) das Verarbeiten Folgendes umfasst:
Ausführen eines Anfangslinienschnitts, einer tiefen schrägen Schnittebene, eines "Reduct to device"-Schnitts, einer Gangverlängerung und eines Gangabschrägens, wobei für die tiefe schräge Schnittebene die Verarbeitung umfasst, eine Öffnungsebene in einem vorgegebenen konfigurierten Winkel zu einer Mittellinienrichtung auszurichten und alles Material unter der Öffnung zu entfernen, eine Ganglänge von der Öffnung zu einer Gangspitze als die Hüllenhöhe zu definieren und den Gang entlang einer Mittellinie um einen vorgegebenen konfigurierbaren Wert zu verlängern und einen Empfänger in einem vorgegebenen konfigurierbaren Abstand von der Gangspitze zu positionieren.

20. Computerlesbare Medien, die Software-Algorithmen von computerlesbarem Code umfassen, die auf einem Prozessor ausgeführt werden können, wobei der Algorithmus Folgendes umfasst:
einen Algorithmus zum Eingeben eines Arbeitsauftrags für eine Hörhilfe, der ein digitalisiertes 3D-Hüllenmodell mit Merkmaldaten enthält;
einen Algorithmus zum Ausführen eines Glättens und/oder eines Lochfüllens und/oder eines Ausreißerentfernens und/oder eines "Renderings" anhand des Hüllenmodells;
einen Algorithmus zum Analysieren des Hüllenmodells, um Merkmale zu erkennen und relevante Parameter, die den Merkmalen zugeordnet sind, zu bestimmen;
einen Algorithmus zum Registrieren und Speichern in einem Datenspeicher der erkannten Merkmale und zugeordneten Parameter;
einen Algorithmus zum Implementieren einer auf Regeln beruhenden Protokollbearbeitung für das Hüllenmodell, die anhand eines bestimmten Hüllentyps bestimmt ist;
einen Algorithmus zum Ausführen von globalen und lokalen Versetzungen an Daten, die dem Hüllenmodel zugeordnet sind; und
einen Algorithmus zum Ausführen einer binauralen Verarbeitung an verbesserten Detaillierungs- und Modellierungsprotokollen, die an dem Hüllenmodell verwendet werden.

## Revendications

1. Procédé pour la conception et la construction d'une prothèse auditive, comprenant les étapes suivantes :
recevoir (12) un ordre de travail pour une prothèse auditive qui comprend un modèle numérique de coque 3D ;
effectuer (20) au moins une opération parmi les suivantes : un lissage, un remplissage de trou, l'élimination de valeurs aberrantes, et un rendu basé sur le modèle de coque ;
analyser (32) le modèle de coque pour reconnaître des caractéristiques et déterminer les paramètres pertinents associés aux caractéristiques ;
enregistrer et stocker (34), dans une mémoire de données, les caractéristiques reconnues et les paramètres associés ;
mettre en oeuvre (38) une gestion de protocole à base de règles pour le modèle de coque qui est déterminé sur la base d'un type de coque déterminé ;
effectuer (40) des compensations globales et locales sur des données associées au modèle de coque ;
effectuer (42) un traitement binaural sur les protocoles augmentés de détaillage et de modélisation utilisés sur le modèle de coque ; et
créer une prothèse auditive sur la base du modèle d'enveloppe traité selon les étapes précédentes.

2. Procédé selon la revendication 1, dans lequel les protocoles augmentés de détaillage et de modélisation comprennent des opérations de rétrécissement, d'arrondi et d'extension de canal.

3. Procédé selon la revendication 1, dans lequel la gestion de protocole à base de règles détermine le placement des composants.

4. Procédé selon la revendication 1, comprenant en outre de configurer un certain nombre de paramètres associés à la coque et de les stocker.

5. Procédé selon la revendication 1, comprenant en outre d'aider au placement des composants et de garantir que des collisions ne se produisent pas, ce qui dépend du type de dispositif.

6. Procédé selon la revendication 1, comprenant en outre d'aider à placer une plaque frontale sur la coque de la prothèse auditive.

7. Procédé selon la revendication 1, comprenant en outre de déterminer un indice de constructibilité pour le modèle de coque.

8. Procédé selon la revendication 1, comprenant en outre d'exécuter automatiquement des coupes de détaillage sur le modèle de coque.

9. Procédé selon la revendication 1, comprenant en outre de placer les composants de manière à ce qu' il y ait une distance acceptable minimale entre les composants.

10. Procédé selon la revendication 1, comprenant en outre de charger dynamiquement et d'exécuter des règles basées sur le dispositif en fonction d'un type de dispositif.

11. Procédé selon la revendication 1, comprenant en outre de placer des composants électroniques sur la base de règles assignées pour le type de dispositif.

12. Procédé selon la revendication 1, comprenant en outre de fournir une interface utilisateur permettant des ajustements angulaires mineurs manuels pour des coupes primaires et cosmétiques.

13. Procédé selon la revendication 1, dans lequel le traitement comprend de réaliser une coupe linéaire initiale, une coupe arrondie de fornix intertragique, un plan de coupe arrondie de branche, un plan de coupe d'angle faible, une coupe « reduct to device », un rétrécissement de canal, une réduction de l'hélix, un creusement de branche, un enlèvement d'artefact et une extension de canal.

14. Procédé selon la revendication 1, dans lequel, pour un dispositif dans l'oreille (ITE), le traitement comprend les étapes suivantes :
insérer un contour de coupe initiale au niveau d'un centre de tragus, d'un centre d'antitragus, et de l'antihélix ;
enlever toute la matière au-dessous d'une extrémité creuse de la coque ; et
reconnaitre et retirer une extrémité inférieure de l'incisure intertragique.

15. Procédé selon la revendication 14, comprenant en outre les étapes suivantes :
catégoriser un attribut dans une pluralité de catégories de tailles ; et
associer une valeur à la catégorie de tailles de l'attribut ; et
utiliser la valeur associée pour réaliser les opérations de rétrécissement, de longueur et d'arrondi.

16. Procédé selon la revendication 1, dans lequel, pour un dispositif de prothèse auditive en demi-coque (HS), le traitement comprend de réaliser une coupe linéaire initiale, une coupe arrondie de fornix intertragique, un plan de coupe d'angle faible, une coupe « reduct to device », un rétrécissement de canal et une réduction de canal.

17. Procédé selon la revendication 1, dans lequel, pour un dispositif de prothèse auditive de canal (CA), le traitement comprend les étapes suivantes :
identifier toutes les caractéristiques requises pour détailler un canal ;
reconnaitre et retirer une conque en insérant un plan de coupe le long d'une branche en utilisant un niveau configuré prédéterminé d'arrondi ;
réaliser une coupe d'angle faible initiée au niveau d'une incisure intertragique et d'un pic de courbure de conque.

18. Procédé selon la revendication 1, dans lequel, pour un dispositif de prothèse auditive de canal miniature (MC), le traitement comprend les étapes suivantes :
identifier et retirer une conque en insérant un plan de coupe le long d'une branche, avec un niveau configurable prédéterminé d'arrondi ;
retirer toute la matière derrière une coque configurée ayant un arrondi configuré ;
insérer une coupe d'angle faible selon un angle configuré prédéterminé à partir d'une incisure intertragique et d'un pic de courbure de conque ;
abaisser une plaque frontale jusqu'à juste avant qu'une collision se produise avec des composants internes ou la coque ; et
placer un récepteur à proximité d'un canal et au-dessous d'une ouverture à une distance configurable prédéfinie d'une extrémité du canal.

19. Procédé selon la revendication 1, dans lequel, pour un dispositif intégralement intégré dans le canal (CIC), le traitement comprend les étapes suivantes :
réaliser une coupe linéaire initiale, un plan de coupe d'angle faible, une coupe « reduct to device », une extension de canal, et un rétrécissement de canal, où, pour le plan de coupe d'angle faible, le traitement comprend d'orienter un plan d'ouverture à un angle configuré prédéterminé vers une direction médiane et de retirer toute la matière au-dessous de l'ouverture, configurer une longueur de canal depuis l'ouverture jusqu'à une extrémité de canal en tant que hauteur de la coque, et étendre le canal le long d'une ligne médiane d'une valeur configurable prédéterminée, et placer un récepteur à une distance configurable prédéterminée à partir de l'extrémité du canal.

20. Support lisible par ordinateur comprenant des algorithmes logiciels en code lisible par ordinateur qui peuvent être exécutés sur un processeur, les algorithmes comprenant :
un algorithme pour entrer un ordre de travail pour une prothèse auditive qui comprend un modèle numérique de coque 3D ayant des données de caractéristiques ;
un algorithme pour effectuer au moins une opération parmi les suivantes : un lissage, un remplissage de trou, l'élimination de valeurs aberrantes et un rendu basé sur le modèle de coque ;
un algorithme pour analyser le modèle de coque pour reconnaître des caractéristiques et déterminer les paramètres pertinents associés aux caractéristiques ;
un algorithme pour enregistrer et stocker, dans une mémoire de données, les caractéristiques reconnues et les paramètres associés ;
un algorithme pour mettre en oeuvre une gestion de protocole à base de règles pour le modèle de coque qui est déterminé sur la base d'un type de coque déterminé ;
un algorithme pour effectuer des compensations globales et locales sur des données associées au modèle de coque ; et
un algorithme pour effectuer un traitement binaural sur les protocoles augmentés de détaillage et de modélisation utilisés sur le modèle de coque.
